# EUROPEAN PATENT APPLICATION

(11) **EP 4 542 794 A1**
(43) Date of publication of application: **23.04.2025**
(21) Application number: 23823549.3
(22) Date of filing: 28.04.2023
(51) Int. Cl.: H01S 3/00, G04F 5/14, H01S 1/06

(54) **MAGNETIC OPTICAL TRAP DEVICE, PHYSICAL PACKAGE, PHYSICAL PACKAGE FOR OPTICAL LATTICE WATCH, PHYSICAL PACKAGE FOR ATOMIC WATCH, PHYSICAL PACKAGE FOR ATOMIC INTERFEROMETER, PHYSICAL PACKAGE FOR QUANTOM INFORMATION PROCESSING DEVICE, AND PHYSICAL PACKAGE SYSTEM**

(30) Priority: 14.06.2022 JP 2022096079
(71) Applicant: RIKEN, Wako-shi, Saitama 351-0198 (JP); JEOL Ltd., Akishima-shi, Tokyo 196-8558 (JP)
(72) Inventor: KATORI, Hidetoshi, Wako-shi, Saitama 351-0198 (JP); TAKAMOTO, Masao, Wako-shi, Saitama 351-0198 (JP); TSUJI, Shigenori, Akishima-shi, Tokyo 196-8558 (JP)
(74) Representative: Boult Wade Tennant LLP
(86) International application number: PCT/JP2023/016938
(87) International publication number: WO 2023/243246

(57) **Abstract**

According to the present invention, atoms are trapped by means of a quadrupole magnetic field formed by ring-shaped magnets (106), (108) and three sets of laser beam pairs. A portion of the laser beam pairs LZ is partially blocked by the ring-shaped magnets (106), (108), so that a region (114) which is a non-atom trap space is formed inside a intersecting region (112) where the three groups of laser beam pairs cross. The inside of the intersecting region (112) is irradiated with a laser beam (118) so that atoms within the non-atom catch space are extracted from intersecting region (112).

## Description

### TECHNICAL FIELD

The present invention relates to a magneto-optical trap device, a physics package, a physics package for an optical lattice clock, a physics package for an atomic clock, a physics package for an atomic interferometer, a physics package for a quantum information processing device, and a physics package system.

### BACKGROUND

An optical lattice clock is an atomic clock that was proposed in the year 2001 by Hidetoshi Katori, one of the inventors of the present invention. The optical lattice clock, which confines an atomic cloud within an optical lattice formed by laser beams and measures a resonance frequency of a visible light region, enables measurement with a precision of 18 digits, far exceeding precision of cesium clocks that are presently available. The optical lattice clocks are now eagerly being researched and developed by the group of the present inventors, and also by various groups in and out of Japan, and are now emerging as next-generation atomic clocks.

Recent techniques for the optical lattice clocks are disclosed in Patent Documents 1 to 3 listed below. Patent Document 1 discloses forming a one-dimensional moving optical lattice inside an optical waveguide having a hollow passageway. Patent Document 2 discloses a configuration in which an effective magic frequency is set. For example, a magic wavelength is theoretically and experimentally determined for each of strontium, ytterbium, mercury, cadmium, and magnesium. Patent Document 3 discloses a radiation shield that reduces influences from black body radiation emanating from walls at the periphery.

The optical lattice clock, which performs time measurement with high precision, enables detection of an altitude difference of 1 cm on the earth based on a general relativity effect due to the force of gravity, as a deviation of progression of time. Thus, achieving smaller and portable optical lattice clocks for use in fields outside of a research laboratory would widen application possibilities of the optical lattice clocks for new geodetic techniques such as search for underground resources and detection of underground openings or magma reservoirs, for example. Producing the optical lattice clocks on a massive scale and placing the optical lattice clocks in various places to continuously monitor a variation in time of the gravity potential enables applications such as detection of crustal movement and spatial mapping of a gravitational field. In this manner, optical lattice clocks are expected to contribute to society as a new fundamental technology, beyond a frame of highly precise time measurement.

A typical physics package for an optical lattice clock includes an atomic oven, a Zeeman slower, and a magneto-optical trap device (MOT). The atomic beams emitted from the atomic oven are cooled by the Zeeman slower, and propagate along the magneto-optical trap device.

Typically, the Zeeman slower includes a bore and a magnetic field generator that generates a magnetic field along a center axis of the bore. The Zeeman slower decelerates, through Zeemanslowing technique, a velocity of an atomic beam emitted from the atomic oven and having a high initial velocity to a velocity at which the beam can be trapped by the magneto-optical trap. The interior of the bore is irradiated by a laser beam passing through an opening of the bore. This laser beam travels in a direction opposite to the traveling direction of the atomic beam, and has a frequency obtained by correcting a Doppler shift term from an atomic transition resonance frequency. The high radiation power of this laser beam decelerates the atomic beam. Further, by forming, with the magnetic field generator, a magnetic field with a spatial gradient centered at the bore, a change of the Doppler shift due to the deceleration can be compensated for with the Zeeman shift, to thereby achieve a situation in which the laser for deceleration always resonates with respect to the atom.

The magneto-optical trap device placed behind the Zeeman slower traps atoms with multiple laser beams and a quadrupole magnetic field formed about a position where the atoms are trapped.

The frequency of the laser beam is set to a value that is negatively detuned from the resonance frequency of the atom. At the time of absorption of a photon of the laser beam by the atom, the photon momentum is applied to the atom and exerts a radiation pressure to the atom. During the motion of the atom at a finite velocity, the frequency of the laser beam opposite to the motion is subjected to Doppler shift toward the resonance frequency of the atom. Meanwhile, the frequency of the laser beam parallel to the direction of the motion is subjected to Doppler shift away from the resonance frequency of the atom. Thus, the atom is more strongly subjected to the radiation pressure from the laser beam opposite to the motion, which results in deceleration of the atom.

Further, the quadrupole magnetic field enables to generate position-dependent radiation pressure. Specifically, position-dependent radiation pressure is such a radiation pressure that is more strongly subjected to Zeeman shift as the resonance frequency of the atom is further away from the center of the trap space. Also, selection of polarization of the laser beam enables change of the application direction of the radiation pressure toward the center.

As described above, a combination of the Zeeman slower and the magneto-optical trap device enables to decelerate the high-velocity atoms and to trap the atoms into the trap space.

When strontium atoms are used as an atom source, for example, a laser beam having a wavelength of 461 nm (corresponding to the energy of ¹S₀-¹P₁ transition) is employed for a slowing and trapping laser beam.

Here, a technique for loading trapped cold atoms into the following device is known.

One technique in which moving molasses are employed is known (see Patent Document 4). For a magneto-optical trap laser beam, by positively shifting the frequency of the laser beam along the direction in which the cold atoms are to be moved and negatively shifting the frequency of the laser beam along the opposite direction, the cold atoms can be moved from the trap position while still cool.

A further technique in which a mirror having a hole is employed is known (see Non-Patent Document 1). Specifically, a laser beam along the direction in which cold atoms are to be moved is reflected back in the opposite direction to generate a counter-propagating laser beam pair, is generated from reflection light of a laser beam that makes the pair. A mirror to generate counter-propagating laser beam pair has a hole in the center, and the mirror is disposed close to a position contacting a region where a plurality of laser beam pairs intersects each other. This configuration allows the hole to form a column region where the laser beam is not reflected. Cold atoms entering that region are subject to the radiation pressure in the direction of exit through the hole, resulting in the cold atoms being probabilistically extracted through the hole of the mirror. This similarly applies to a configuration including a conical mirror or a pyramidal mirror, for example, having a hole along the center axis.

A further technique is known in which a partially light-blocking member is disposed in the optical path of two of three mutually orthogonal, counter-propagating pairs of laser beams. According to this technique, in a region where the three sets of laser beam pairs intersect, not only an isotropic radiation pressure but also an axial radiation pressure is generated along the direction away from the region. This axial radiation pressure causes probabilistic extraction of the cold atoms.

A still further technique is known to change the trapping method from magneto-optical trapping to optical trapping, in which the cold atoms are moved by sweeping the optical field that confines them. (see Patent Document 3).

A further technique is known to change the trapping method from magneto-optical trapping to magnetic trapping, in which the cold atoms are moved by sweeping the magnetic field that confines them. (see Non-Patent Document 2).

A further method is known in which atoms in the magneto-optical trap are optically pumped into a non-trapped state, to extract cold atoms by gravity (see Non-Patent Document 3).

Known methods for generating the quadrupole magnetic field that is necessary for magneto-optical trap include, for example, a method in which anti-Helmholtz coils are used and a method in which a permanent magnet pair providing mutually antiparallel magnetization is used. Patent Document 5 discloses that a magnetic ring extending through a pair of laser beams, among three sets of laser beam pairs, is used along with an excitation coil.

### CITATION LIST

### PATENT LITERATURE

Patent Document 1: JP 6206973 B
Patent Document 2: JP 6635608 B
Patent Document 3: JP 7189588 B
Patent Document 4: US 5274232 A, Description
Patent Document 5: US 10371763 B2, Description

### NON-PATENT LITERATURE

Non-Patent Document 1: Phys. Rev. Lett 77(1996)3331 Z. T. Liu et al.
Non-Patent Document 2: Phys. Rev. A 63(2001)031401 M. Greiner et. al.
Non-Patent Document 3: Phys. Rev. A 46(1992) R17 F. Shimizu et. al.

### SUMMARY

### TECHNICAL PROBLEM

In a device such as an atomic clock or an atomic interferometer, the fundamental technologies of continuous cold atom source, continuous operation and continuous measurement.

The present invention is aimed toward trapping atoms and continuously ejecting the cold atoms to the following device.

### SOLUTION TO PROBLEM

According to one aspect of the present invention, a magneto-optical trap device includes a first former configured to form an atom trap space in which atoms are trapped with a first set of light beams and a magnetic field; a second former configured to form a non-atom-trap space within an intersecting region where light beams in the first set intersect; and a light beam irradiator configured to emit a second light beam into the intersecting region to enable atoms within the non-atom-trap space to be extracted from the intersecting region.

The first former and the second former may include a pair of magnets configured to generate a magnetic field. Each of the magnets may have a hole to allow a light beam to pass through, and the light beam irradiator may irradiate the intersecting region with the second light beam passing through the hole.

The pair of magnets may be disposed on a light path along which part of the first set of light beams travels to partially block part of the first set of light beams. The atom trap space may be formed between the magnets of the pair by light beams of the first set of light beams that are not blocked with the pair of magnets and a magnetic field generated from the pair of magnets. The non-atom trap space may be formed in a space that is blocked light beams by the pair of magnets.

The magneto-optical trap device may further include an auxiliary magnet configured to form the atom trap space.

The second former may include a pair of masks each having a hole to allow a light beam to pass through. The pair of masks may be disposed on a light path along which part of the first set of light beams travels to partially block part of the first set of light beams. The light beam irradiator may irradiate the intersecting region with the second light beam passing through the hole.

The pair of masks may include a paramagnetic material.

The second light beam may be a push laser beam.

The first set of light beams may be laser beams having a wavelength of 461 nm or laser beams having a wavelength of 689 nm.

According to one aspect of the invention, there is provided a physics package including the above-described magneto-optical trap device.

According to one aspect of the invention, there is provided a physics package for an optical lattice clock including the above-described physics package.

An embodiment of the invention provides a physics package for an atomic clock including the above-described physics package.

An embodiment of the invention provides a physics package for an atomic interferometer including the above-described physics package.

According to one aspect of the invention, there is provided a physics package for a quantum information processing device for atoms or ionized atoms, including the above-described physics package.

According to one aspect of the invention, there is provided a physics package system including the above-described physics package, and a control device configured to control operation of the physics package.

### ADVANTAGEOUS EFFECTS

The present invention enables trapping of atoms and ejecting the trapped atoms to the following device.

### BRIEF DESCRIPTION OF DRAWINGS

[FIGURE 1] FIG. 1 is a block diagram illustrating an overall configuration of an optical lattice clock according to an embodiment.
[FIGURE 2] FIG. 2 is a cross sectional view illustrating a schematic configuration of a magneto-optical trap device according to a first embodiment.
[FIGURE 3] FIG. 3 is a cross sectional view illustrating a schematic configuration of the magneto-optical trap device according to the first embodiment.
[FIGURE 4] FIG. 4 is a perspective view illustrating a pair of magnets.
[FIGURE 5] FIG. 5 shows calculation results of a magnetic field distribution formed by the magneto-optical trap device according to the first embodiment.
[FIGURE 6] FIG. 6 shows calculation results of a magnetic field distribution formed by the magneto-optical trap device according to the first embodiment.
[FIGURE 7] FIG. 7 shows calculation results of a magnetic field distribution formed by the magneto-optical trap device according to the first embodiment.
[FIGURE 8] FIG. 8 shows calculation results of a magnetic field distribution formed by the magneto-optical trap device according to the first embodiment.
[FIGURE 9] FIG. 9 is a perspective view illustration a modification example of a pair of magnets.
[FIGURE 10] FIG. 10 is a perspective view illustration a modification example of a pair of magnets.
[FIGURE 11] FIG. 11 schematically illustrates a physics package.
[FIGURE 12] FIG. 12 is a cross sectional view schematically illustrating a magneto-optical trap device according to a second embodiment.
[FIGURE 13] FIG. 13 shows calculation results of a magnetic field distribution formed by the magneto-optical trap device according to the second embodiment.
[FIGURE 14] FIG. 14 shows calculation results of a magnetic field distribution formed by the magneto-optical trap device according to the second embodiment.
[FIGURE 15] FIG. 15 illustrates five laser beams.
[FIGURE 16] FIG. 16 is a cross sectional view schematically illustrating a magneto-optical trap device according to a third embodiment.
[FIGURE 17] FIG. 17 is a cross sectional view for explaining a method of loading a pair of magnets.
[FIGURE 18] FIG. 18 is a cross sectional view for explaining a method of loading a pair of magnets.

### DESCRIPTION OF EMBODIMENTS

### <Configuration of Optical Lattice Clock>

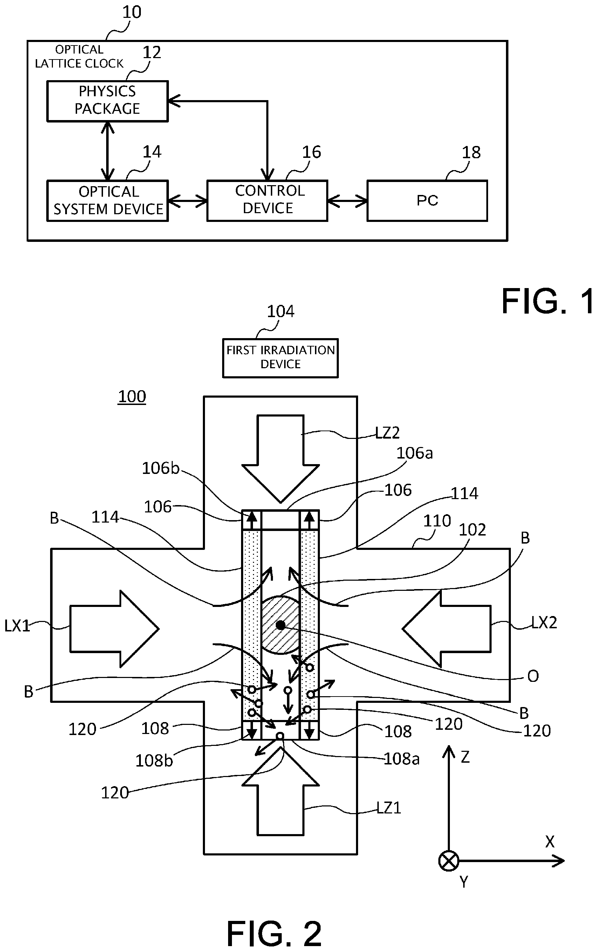

Referring to FIG. 1, a schematic configuration of an optical lattice clock 10 for which a magneto-optical trap device according to an embodiment is employed will be described. FIG. 1 is a block diagram illustrating an overall configuration of the optical lattice clock 10. While in this example, the optical lattice clock 10 will be described as an example of a device for which the magneto-optical trap device according to the embodiment is employed, the magneto-optical trap device according to the embodiment may be used for devices other than the optical lattice clock 10.

The optical lattice clock 10 includes, for example, a physics package 12, an optical system device 14, a control device 16, and a PC (Personal Computer) 18.

The physics package 12 is a device that traps an atomic cloud, confines the atoms in an optical lattice, and causes a clock transition. The optical system device 14 includes optical devices such as a laser beam source for trapping atoms, a laser beam source for exciting clock transition, and a laser frequency control device, for example. The optical system device 14, in addition to transmitting a laser beam to the physics package 12, performs processing including receiving a fluorescence signal emitted from the atomic cloud in the physics package 12, converting the received signal into an electrical signal, and feeding back to the laser beam source so that the frequency matches the resonance frequency of the atom. The control device 16 controls the physics package 12 and the optical system device 14. The control device 16 performs operation control of the physics package 12, operation control of the optical system device 14, and analysis processing such as frequency analysis of the clock transition obtained through measurements. The physics package 12, the optical system device 14, and the control device 16 cooperate with each other to implement the functions of the optical lattice clock 10.

The PC 18 is a general-purpose computer including a processor and a memory. Software is executed by hardware including the processor and the memory, to implement the functions of the PC 18. An application program for controlling the optical lattice clock 10 is installed in the PC 18. The PC 18 is connected to the control device 16, and may control not only the control device 16, but also the entirety of the optical lattice clock 10 including the physics package 12 and the optical system device 14. In addition, the PC 18 provides a UI (User Interface) of the optical lattice clock 10. A user can start the optical lattice clock 10, perform time measurement, and check results through the PC 18.

A system including the physics package 12 and a structure necessary for control of the physics package 12 may be referred to as a "physics package system". The structure necessary for control may be included in the control device 16 or in the PC 18, or in the physics package 12. Alternatively, part or all of the functions of the control device 16 may be included in the physics package 12.

The magneto-optical trap device according to embodiments will be described in detail below.

### <Magneto-Optical Trap Device according to First Embodiment>

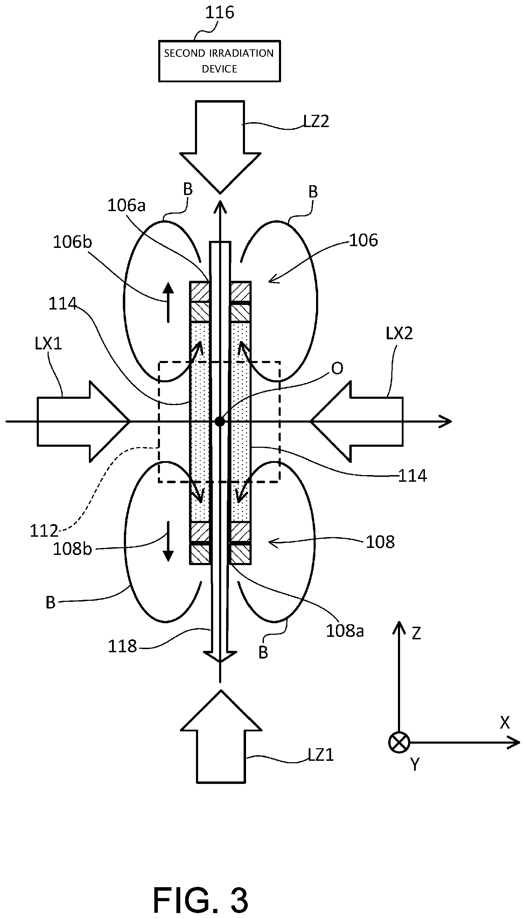

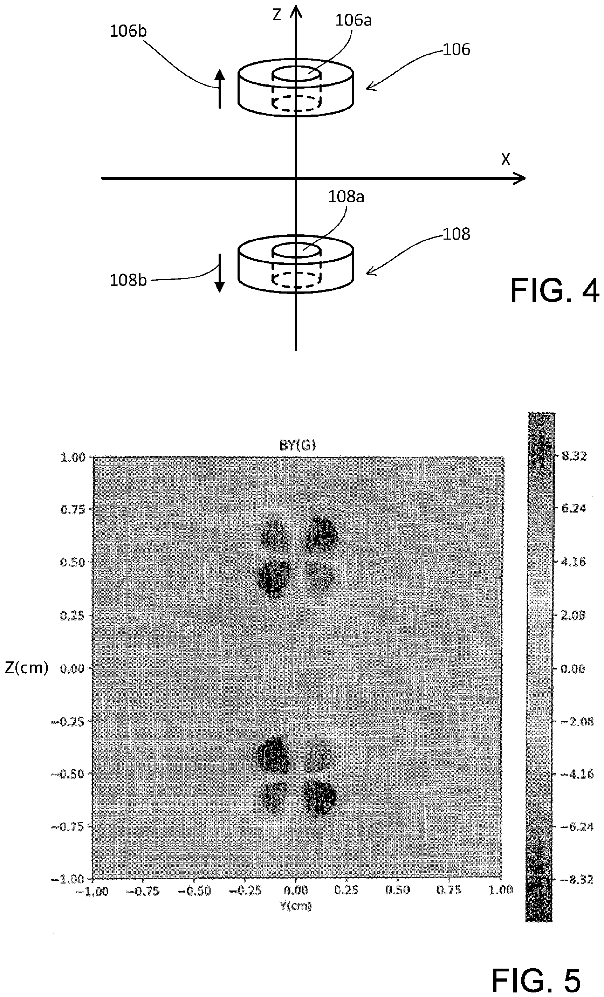

Referring to FIG. 2 to FIG. 4, a magneto-optical trap device 100 according to a first embodiment will be described. FIG. 2 and FIG. 3 are cross sectional views schematically illustrating a configuration of the magneto-optical trap device 100 according to the first embodiment, and FIG. 4 is a perspective view illustrating a pair of magnets.

Here, a coordinate system composed of an X axis, a Y axis, and a Z axis that are orthogonal to one another is defined. A point where the X axis, the Y axis, and the Z axis intersect one another is defined as a center O of an atom trap space 102. The center O corresponds to a point of symmetry of a quadrupole magnetic field B for magneto-optical trap.

The magneto-optical trap device 100 includes a vacuum chamber, a first irradiation device 104 that emits a laser beam to the atom trap space 102 for atoms, and a pair of magnets (a pair of magnets composed of a magnet 106 and a magnet 108), which is one example of a magnetic field generation device that generates the quadrupole magnetic field B.

The first irradiation device 104 includes one or more light sources that emit laser beams, and one or more optical elements (e.g., mirrors or beam splitters) that direct the laser beams emanating from the one or more light sources to the atom trap space 102. The first irradiation device 104 emits three sets of laser beam pairs that are mutually orthogonal. The three sets of laser beam pairs are composed of a total of six resonance laser beams that are negatively detuned with respect to a target atom.

Specifically, the three sets of laser beam pairs include a laser beam pair LX emanating along the X axis, a laser beam pair LY emanating along the Y axis, and a laser beam pair LZ emanating along the Z axis.

The laser beam pair LX is composed of a laser beam LX1 that travels in the positive direction along the X axis and a laser beam LX2 that travels in the negative direction along the X axis (i.e., a laser beam that travels in the opposite direction to the traveling direction of the laser beam LX1).

The laser beam pair LY, although not shown in FIG. 2 and FIG. 3, is composed of a laser beam LY1 that travels in the positive direction along the Y axis and a laser beam LY2 that travels in the negative direction along the Y axis (i.e., a laser beam that travels in the opposite direction to the traveling direction of the laser beam LY1).

The laser beam pair LZ is composed of a laser beam LZ1 that travels in the positive direction along the Z axis and a laser beam LZ2 that travels in the negative direction along the Z axis (i.e., a laser beam that travels in the opposite direction to the traveling direction of the laser beam LZ1).

FIG. 2 schematically illustrates a region 110 irradiated with the laser beams. FIG. 3 indicates an intersecting region 112 with dashed lines. The intersecting region 112 is a region where the three sets of laser beam pairs intersect with one another. Atoms within the intersecting region 112 interact with the three sets of laser beam pairs, such that a radiation pressure is applied to the atoms from a direction opposite to the direction of the motion of the atoms.

In the intersecting region 112, the quadrupole magnetic field B causes space dependency in the radiation pressure, and the radiation pressure having space dependency acts as a restoring force for the atoms that is directed toward the center point of the quadrupole magnetic field B.

The quadrupole magnetic field B is generated by the pair of magnets (the magnets 106 and 108) described above. The magnets 106 and 108 are ring-shaped magnets, for example. The magnet 106 has, in the center, a hole 106a that passes through the magnet 106 in the magnetization direction. Similarly, the magnet 108 has, in the center, a hole 108a that passes through the magnet 108 in the magnetization direction. The holes 106a and 108a may have a circular shape or a rectangular shape.

The magnets 106 and 108 are permanent magnets magnetized along the Z axis, for example. In other words, the magnets 106 and 108 are disposed on the Z axis such that the magnetization direction is parallel to the direction of the Z axis. More specifically, the magnets 106 and 108 are disposed at opposite sides about the center O of the intersecting region 112 such that the magnetization direction 106b of the magnet 106 and the magnetization direction 108b of the magnet 108 are opposite to each other. The distance between the magnet 106 and the center O is equal to the distance between the magnet 108 and the center O. The magnets 106 and 108 are disposed close to the intersecting region 112 so as not to block the laser beam pairs LX and LY.

The magnets 106 and 108 have widths in the X axis direction and Y axis direction that are smaller than the diameters of the laser beam LZ1 and LZ2. The magnets 106 and 108 disposed on the Z axis partially block the laser beams LZ1 and LZ2, respectively. This results in formation of a region 114 that is not irradiated with the laser beam LZ1 or LZ2 within the intersecting region 112. The region 114 where the light is blocked by the magnets 106 and 108 and corresponds to a non-atom-trap space.

Specifically, the magnets 106 and 108 are disposed on an optical path of laser beam pair LZ, which is one of the three laser beam pairs, to partially block the laser beam pair LZ (that is, the laser beams LZ1 and LZ2). Thus, laser beams that are not blocked with the magnets 106 and 108 (i.e., laser beams including the laser beam pair LX, the laser beam pair LY, and part of the laser beams of the laser beam pair LZ that are not blocked), and the quadrupole magnetic field B formed by the magnets 106 and 108, form the atom trap space 102. Further, the region 114 corresponding to the non-atom-trap space is formed in the space where the light is blocked by the magnets 106 and 108.

The magneto-optical trap device 100 further includes a second irradiation device 116. The second irradiation device 116 includes a light source that emits a laser beam, and one or more optical elements (e.g., mirrors or beam splitters) that direct the laser beam emanating from the light source to the intersecting region 112. The intersecting region 112 is irradiated with a laser beam 118 by the second irradiation device 116. The laser beam 118 irradiates the atom trap space 102 along the Z axis through the hole 106a of the magnet 106 and the hole 108a of the magnet 108.

The relationship among the size (diameter, for example) of the magnets 106 and 108, the size (diameter, for example) of the holes 106a and 108a, and the diameter of the laser beam (laser beam LZ1, for example) for magneto-optical trap is as follows: Size of hole 106a, 108a < size of magnet 106, 108 < diameter of laser beam for magneto-optical trap

The laser beam 118 is a laser beam used for optical trapping of atoms. An example of optical trapping includes a method of trapping atoms with an optical dipole force using the light field. According to this method, the laser beam 118 is a laser beam for optical dipole trapping. A further example method traps atoms with standing waves of light. According to this method, the laser beam 118 is a laser beam for an optical lattice. According to a still further example method, the laser beam 118 may be a push laser beam resonant on an atomic transition. According to this method, by using a radiation force, it is possible to apply the driving force to propel atoms.

Here, the three sets of laser beams correspond to an example of a first set of light beams, the first irradiation device 104 and the magnets 106 and 108 correspond to an example of a first former, the magnets 106 and 108 correspond to a second former, the second irradiation device 116 corresponds to an example of a light irradiator, and the laser beam 118 corresponds to an example of second light.

The operation of the magneto-optical trap device 100 will be described below.

The first irradiation device 104 emits the laser beam pairs LX, LY, and LZ to form the intersecting region 112. The magnets 106 and 108 form the quadrupole magnetic field B. The second irradiation device 116 irradiates the atom trap space 102 with the laser beam 118.

The atoms within the intersecting region 112, receiving a radiation pressure acting as a restoring force, move toward the center O of the quadrupole magnetic field B while decreasing the velocity.

As described above, the intersecting region 112 includes the region 114 where the light is blocked by the magnets 106 and 108. The region 114 is irradiated with the laser beam pairs LX and LY, and is not irradiated with the laser beam pair LZ. In this region 114, the velocity of the atoms relative to the X direction (+X direction, -X direction) and the velocity of the atoms relative to the Y direction (+Y direction, -Y direction) are decreased; however, the velocity of the atoms relative to the Z direction (+Z direction, -Z direction) is not decreased. Therefore, there is no force, acting on the atom within the region 114, in the Z direction of no laser beams and the atoms disperse toward the Z direction. Reference numeral 120 in FIG. 2 indicates atoms in the region 114 are not confined toward Z direction.

It is now assumed that the atoms dispersed in the Z direction are further move outward or inward of the region 114 that is blocked light.

The atom that has moved outward of the region 114, which is irradiated with the laser beam pair LZ, is confined to the center O of the quadrupole magnetic field B by the laser beam pairs LX, LY, and LZ and the quadrupole magnetic field B.

Meanwhile, the atom that has moved inward of the region 114 interacts with the laser beam 118. In the illustrated example, the laser beam 118 is emanating toward the - Z direction. When the laser beam 118 is a push laser beam, the atom are subject to a radiation pressure and propelled in the Z direction. When the laser beam 118 is an optical trap laser beam, the atom can be moved in the -Z direction by externally controlling the potential of the optical trap. The atom that has moved toward the -Z direction is pushed outward of the intersecting region 112 through the hole 108a of the magnet 108.

As described above, atoms are definitely given a momentum with respect to the traveling direction of the laser beam 118 to be extracted from the intersection region 11. This enables continuous ejecting the cold atom to a device at the following stage. For example, to move the atoms trapped within the atom trap space 102, it is not necessary to turn off the laser beam pairs LX, LY, or LZ for ejecting the cold atom to the following device.

In a specific example of the first embodiment, the laser beam pairs LX, LY, and LZ have a wavelength of 689 nm. In an example, the width (outer diameter) of the magnets 106 and 108 in the X direction and the Y direction is about 0.8 mm, the width (inner diameter) of the holes 106a and 108a in the X direction and the Y is about 0.27 mm, and the distance between the magnet 106 and the magnet 108 is from about 10 mm to about 15 mm.

FIG. 5 to FIG. 8 show calculation results of a magnetic field distribution generated by the magnet 106 and the magnet 108.

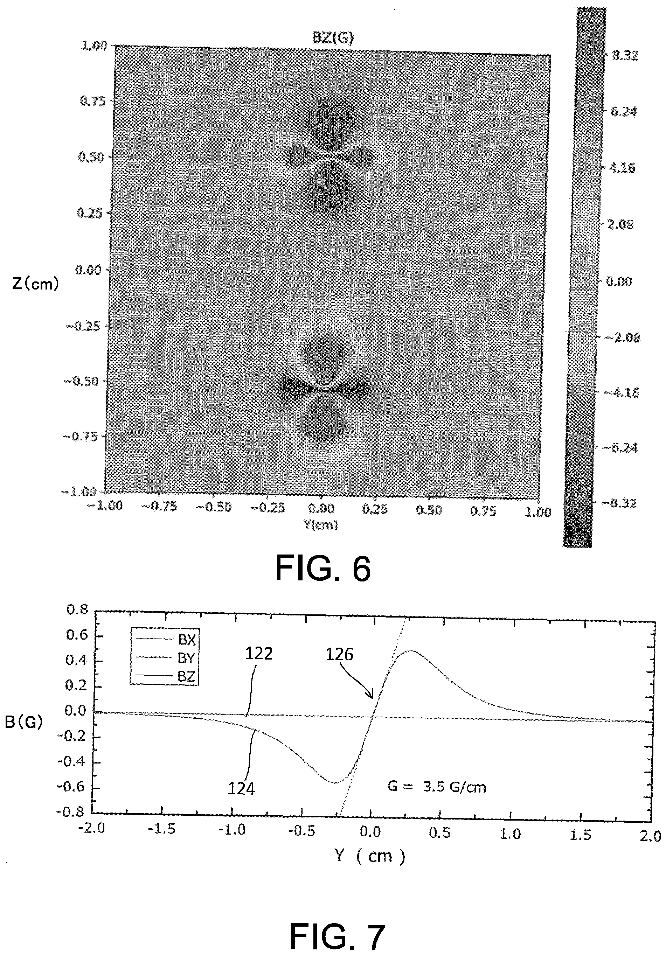

The calculated values shown in FIG. 5 represent values (BY(G)) of Y components of the magnetic field within a YZ plane (a plane formed by the Y axis and the Z axis). The calculated values shown in FIG. 6 represent values (BZ(G)) of Z components of the magnetic field within the YZ plane. The magnetic field are expressed with grey scale.

FIG. 7 shows calculation results of magnetic field components on the Y axis. In FIG. 7, the horizontal axis indicates positions on the Y axis, and the vertical axis indicates calculated values of the magnetic field. Reference numeral 122 denotes the calculated values (BX) of the X components of the magnetic field and the calculated values (BZ) of the Z components of the magnetic field. Reference numeral 124 denotes the calculated values (BY) of the Y components of the magnetic field. As indicated with reference numeral 126, the magnetic field gradient between -2 mm an + 2 mm is evaluated at + 3.5 G/cm.

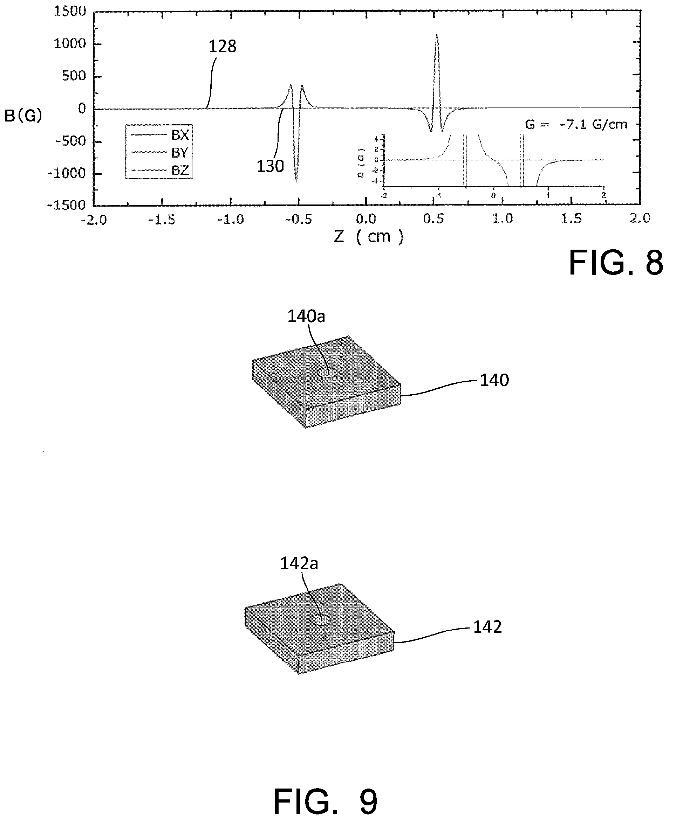

FIG. 8 shows calculation results of magnetic field components on the Z axis. In FIG. 7, the horizontal axis indicates positions on the Z axis, and the vertical axis indicates calculated values of the magnetic field. Reference numeral 128 denotes the calculated values (BX) and the calculated values (BZ). Reference numeral 130 denotes the calculated values (BY). The magnetic field gradient between -2 mm an + 2 mm is evaluated at - 7.1 G/cm.

As shown in FIGs. 7 and 8, in the first embodiment, the quadrupole magnetic field having a relatively small magnetic field gradient is formed. The magneto-optical trap utilizing this quadrupole magnetic field and the laser beam having a wavelength of 689 nm can cool the atoms down to the temperature of about µK. The atoms cooled to the temperature of about µK are ejected from the magneto-optical trap device 100 to the following device.

As described above, the ring-shaped magnets 106 and 108 act as to block the laser beam pairs. This configuration allows the cold atoms to be ejected from the magneto-optical trap device to the following device without adding a new configuration. This configuration further enables the cold atoms to be continuously emitted without adjustment of the precise position or parameters of each element.

Atomic beam may adhere to a mask member to contaminate the mask member. When the mask member is an optical element such as a mirror having a hole, the contaminant may deteriorate the optical properties of the optical element. In the first embodiment, however, the magnets 106 and 108 having holes function as masks, which does not cause a problem of deterioration of the optical properties of the optical element.

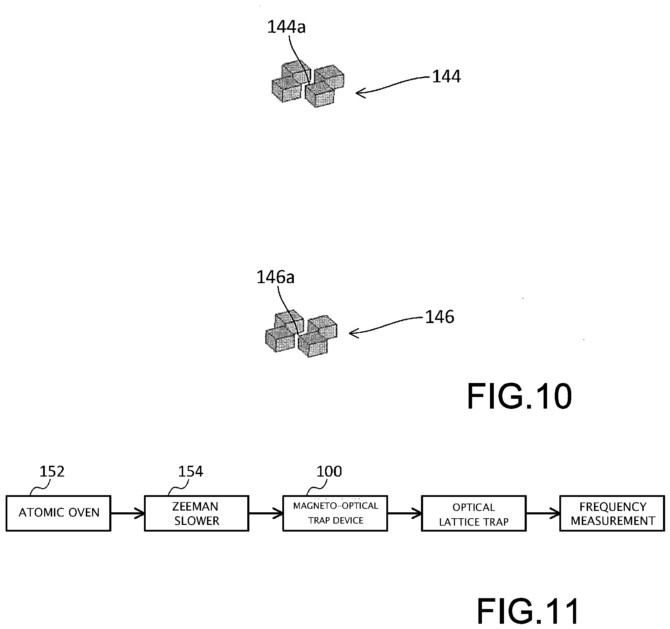

FIG. 9 and FIG. 10 illustrate modification examples of a pair of magnets for generating the quadrupole magnetic field B. FIG. 9 and FIG. 10 are perspective views each illustrating the magnets according to the modification examples.

In the example illustrated in FIG. 9, magnets 140 and 142 consist of a pair of magnets. Each of the magnets 140 and 142 has a rectangular shape. The magnet 140 has a hole 140a that passes through the magnet 140 in the magnetization direction. Similarly, the magnet 142 has a hole 142a that passes through the magnet 142 in the magnetization direction. The magnetization direction of the magnets 140 and 142 is the same as the magnetization direction of the magnets 106 and 108. The laser beam 118 irradiates the atom trap space 102 through the holes 140a and 142a. Similar to the first embodiment described above, the size (the length of diagonal, for example) of the magnet 140, 142, the size (the diameter, for example) of the hole 140a, 142a, and the diameter of the laser beam (laser beam LZ1, for example) for magneto-optical trap have the following relationship: Size of hole140a, 142a < size of magnet 140, 142 < diameter of laser beam for magneto-optical trap

In the example illustrated in FIG. 10, magnets 144 and 146 consist of a pair of magnets. The magnet 144 is composed of a plurality of magnets disposed in an axial symmetrical manner about a hole 144a. Similarly, the magnet 146 is composed of a plurality of magnets disposed in an axial symmetrical manner about a hole 146a. Specifically, each of the magnets 144 and 146 includes four magnet pieces divided in an axial symmetrical manner. The magnetization direction of the magnets 144 and 146 is the same as the magnetization direction of the magnets 106 and 108. The laser beam 118 irradiates the atom trap space 102 through the holes 144a and 146a. Similar to the first embodiment described above, the size of the magnet 144, 146, the size of the hole 144a, 146a, and the diameter of the laser beam for magneto-optical trap have the following relationship: Size of hole144a, 146a < size of magnet 144, 146 < diameter of laser beam for magneto-optical trap

Referring to FIG. 11, a physics package including the magneto-optical trap device 100 will be described. FIG. 11 schematically illustrates a physics package 150.

The physics package 150 includes an atomic oven 152, a Zeeman slower 154, and the magneto-optical trap device 100.

The atomic oven 152 includes a specimen reservoir that houses a specimen, a heater, a temperature sensor, an electric connector, a capillary nozzle, and a thermal radiation shield, for example. The specimen reservoir, for example, is housed in a vacuum chamber having an interior maintained ultra-high vacuum condition. The specimen is heated by the heater to thereby generate atomic vapor. The atomic vapor is emitted through the capillary nozzle toward the Zeeman slower 154. The capillary nozzle produces the oriented and collimated atomic beam by passing the atomic vapor through its capillaries. While strontium and ytterbium may be used as a specimen, other atoms may alternatively be used.

The Zeeman slower 154 includes a bore and a magnetic field generator. The magnetic field generator includes a solenoid coil and generates a magnetic field along the center axis of the bore. The atomic beam emitted from the atomic oven 152 passes through the bore.

The Zeeman slower 154 decelerates, through Zeeman slowing technique, the velocity of the atomic beam emitted from the atomic oven 152 and having a high initial velocity, to a velocity at which the atoms can be trapped by the magneto-optical trap device 100 at the following stage.

The interior of the bore is irradiated with a laser beam from a direction opposite to the traveling direction of the atomic beam. The laser beam may be a laser beam that is also used for magneto-optical trap.

The Zeeman slower 154 decelerates the velocity of the atomic beam emitted from the atomic oven 152 into the bore with the magnetic field generated by the magnetic field generator and the laser beam. The atomic beam having a high temperature travels within the bore toward the magneto-optical trap device 100 while being decelerated according to Zeeman slowing technique by the magnetic field generated by the magnetic field generator and the laser beam.

The atomic oven 152 and the Zeeman slower 154 may be a known atomic oven and a known Zeeman slower, respectively.

As described above, the magneto-optical trap device 100 is installed in a vacuum chamber, and the interior of the vacuum chamber is maintained ultra-high vacuum condition. The interior of the vacuum chamber connects with the bore of the Zeeman slower 154 and the vacuum chamber of the atomic oven 152, to maintain an ultra-high vacuum condition in the bore and the vacuum chamber of the atomic oven 152. The atom trap space 102, the intersecting region 112, and the region 114 (non-atom-trap space) are formed within the vacuum chamber of the magneto-optical trap device 100.

The operation of the physics package 150 will be described below.

In the physics package 150, the interior of the vacuum chamber is vacuumized. The atomic beam emitted from the atomic oven 152 to the Zeeman slower 154 is sufficiently decelerated by Zeeman slowing technique and reaches the magneto-optical trap device 100.

In the magneto-optical trap device 100, the laser beam pairs LX, LY, and LZ and the quadrupole magnetic field B trap the atoms, as described above, and the laser beam 118 probabilistically moves the atoms having a very low temperature outside the intersecting region 112.

An optical lattice trap, for example, is applied to atoms having a very low temperature that have moved outside the intersecting region 112. For example, an optical lattice laser beam enters the vacuum chamber of the magneto-optical trap device 100 and is reflected by an optical cavity disposed within the vacuum chamber. This process creates optical lattice potentials in which standing waves are lined up in the direction of traveling of the optical lattice laser beam. The atomic cloud is trapped in the optical lattice potential. [For example, the laser beam forming the optical lattice in an optical cavity installed in the vacuum chamber creates optical lattice potentials in the trap space, in which standing waves exist in the direction of propagation of the optical lattice laser beams. Atom clouds are trapped in the optical lattice potential.]

By slightly changing the frequency of the optical lattice laser beam, the optical lattice can be moved in the direction of traveling of the optical lattice laser beam. This moving means achieved by the moving optical lattice moves the atomic cloud into a clock transition space.

In the clock transition space, the atoms are irradiated with a laser beam having controlled optical frequency, high precision atomic spectroscopy of the clock transition (that is, resonance transition of the atom which forms a reference of the clock) is performed, and an atomic specific and invariable frequency is measured. This process achieves an accurate atomic clock.

In order to improve the precision of the atomic clock, it is necessary to remove or reduce perturbations surrounding the atoms, and accurately read the absolute frequency of clock transition. Of particular importance is removal of a frequency shift caused by Doppler's effect due to thermal motion of the atoms. The optical lattice clock confines the atoms with the optical lattice created by interference of laser beams within a space sufficiently small relative to the wavelength of the clock laser, to thereby freeze the motion of the atoms. Meanwhile, in the optical lattice, the frequency of the atom is shifted due to the laser beams forming the optical lattice. In this regard, a particular wavelength and a particular frequency called a "magic wavelength" or a "magic frequency" are selected for the optical lattice laser beam to remove the influences of the optical lattice on the resonance frequency.

The light that is emitted as a result of the clock transition is received by the optical system device 14, and spectroscopically processed, for example, by the control device 16, to determine the frequency.

### <Magneto-Optical Trap Device according to Second Embodiment>

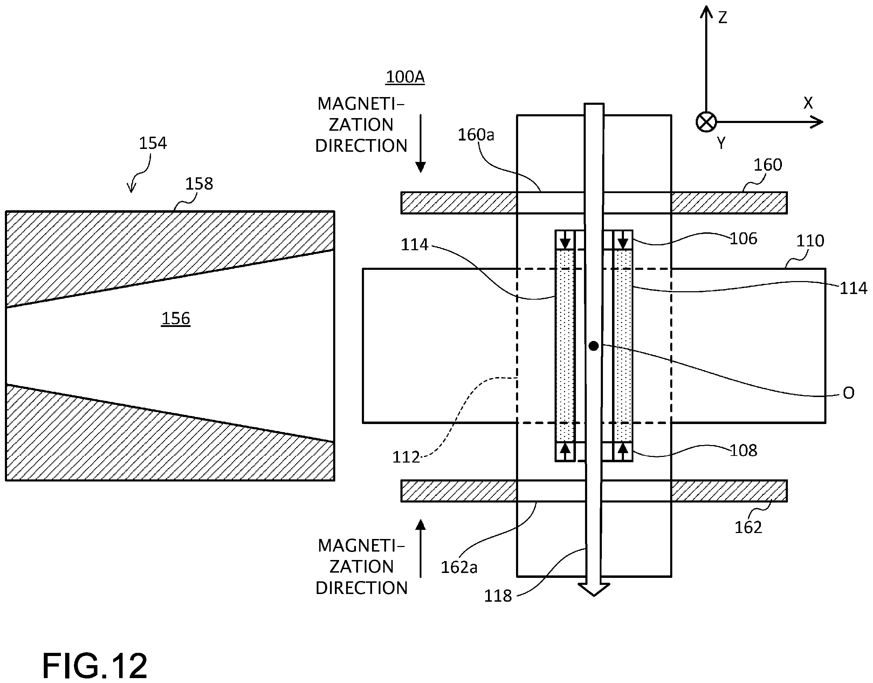

Referring to FIG. 12, a magneto-optical trap device 100A according to a second embodiment will be described. FIG. 12 is a cross sectional view schematically illustrating the magneto-optical trap device 100A according to the second embodiment.

The magneto-optical trap device 100A according to the second embodiment further includes, in addition to the configuration of the magneto-optical trap device 100 according to the first embodiment, a pair of auxiliary magnets. The pair of auxiliary magnets is composed of annular auxiliary magnets 160 and 162. The auxiliary magnet 160 has, in the center, a hole 160a passing through the auxiliary magnet 160 in the magnetization direction. Similarly, the auxiliary magnet 162 has, in the center, a hole 162a passing through the auxiliary magnet 162 in the magnetization direction. The auxiliary magnets 160 and 162 are magnetized along the Z axis. Thus, the auxiliary magnets 160 and 162 are disposed on the Z axis such that the magnetization direction is parallel to the Z axis. Specifically, the auxiliary magnets 160 and 162 are disposed on opposite sides with respect to the center O of the intersecting region 112 at locations further away from the center O than the magnets 106 and 108. The auxiliary magnets 160 and 162 are disposed such that the magnetization direction of the auxiliary magnet 160 and the magnetization direction of the auxiliary magnet 162 are opposite each other. The distance between the auxiliary magnet 160 and the center O and the distance between the auxiliary magnet 162 and the center O are equal to each other. Also, the diameter of the hole 160a of the auxiliary magnet 160 and the diameter of the hole 162a of the auxiliary magnet 162 are larger than the diameter of the laser beam pair LZ. The laser beam pair LZ travels through the holes 160a and 162a, and part of the laser beam pair LZ is blocked by the magnets 106 and 108. Although in the example illustrated in FIG. 12, six laser beams, LX1, LX2, LY1, LY2, LZ1, and LZ2 form the intersecting region 112, this is only one example. Further, FIG. 12 illustrates the Zeeman slower 154 including a bore 156 and a magnetic field generator 158.

In the second embodiment, a quadrupole magnetic field having a relatively large magnetic field gradient (approximately 50 G/cm, for example) is formed. A magneto-optical trap composed of this quadrupole magnetic field and the laser beam having a wavelength of 461 nm cools the atoms to the temperature of approximately mK. To generate a quadrupole magnetic field having such a large magnetic field gradient, high-power magnets made of samarium-cobalt, for example, are used for the magnets 106 and 108. The auxiliary magnets 160 and 162 are installed in such a way that so that the magnetic field generator 158 of the Zeeman slower 154 is seamlessly integrated with the magnetic field of the magnets 106 and 108.

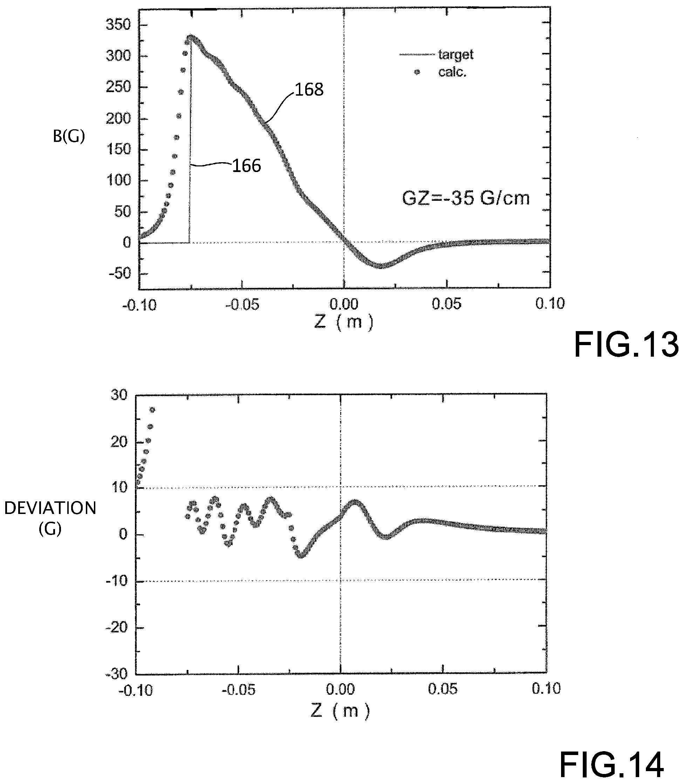

FIG. 13 shows calculation results of a magnetic field distribution formed by the magneto-optical trap device 100A according to the second embodiment. The horizontal axis indicates the positions on the Z axis, and the vertical axis indicates calculation values of the magnetic field. Reference numeral 166 (solid line) indicates calculation results of the ideal magnetic field. Reference numeral 168 (dots) indicates calculation results of the magnetic field formed by the magneto-optical trap device 100A. In FIG. 13, the values indicated by reference numeral 166 and the values indicated by reference numeral 168 substantially correspond to each other.

FIG. 14 shows a difference between the calculation results of the ideal magnetic field and the calculation results of the magnetic field formed by the magneto-optical trap device 100A. The horizontal axis indicates positions on the Z axis and the vertical axis indicates the difference.

According to the second embodiment, the use of the magnets 106 and 108 and the auxiliary magnets 160 and 162 enables formation of the ideal magnetic field distribution.

Further, the calculation value of the magnitude of the magnetic field gradient formed at the center O is 35 G/cm, allowing the quadrupole magnetic fields with relatively large magnetic field gradients to be generated. This further allows to extract the atoms to be cooled down to the temperature in the order of mK.

The magnetization direction of the auxiliary magnets 160 and 162 may be the same as the magnetization direction of the magnets 106 and 108 or may be in radial direction..

A pair of magnets acquired by dividing a cylindrical magnet into 2n (n≧2) pieces may be used as the auxiliary magnets 160 and 162. Such dividing makes the auxiliary magnets 160 and 162 and the laser beam pair LX and LY unlikely to interfere with each other. In a further example, bar magnets or cylindrical magnets, for example, may be disposed at symmetrical positions to form the quadrupole magnetic field.

In the second embodiment, the magnets 106 and 108 may be soft magnets with high permeability. For example, the shape of the soft magnets is designed magnetic flux from the auxiliary magnets 160 and 162 are concentrated and guided by the soft magnets 106 and 108 to form an ideal quadrupole magnetic field near the center O. Further, anti-Helmholtz coils may be used in place of the auxiliary magnets 160 and 162 to adjust the magnetic field distribution.

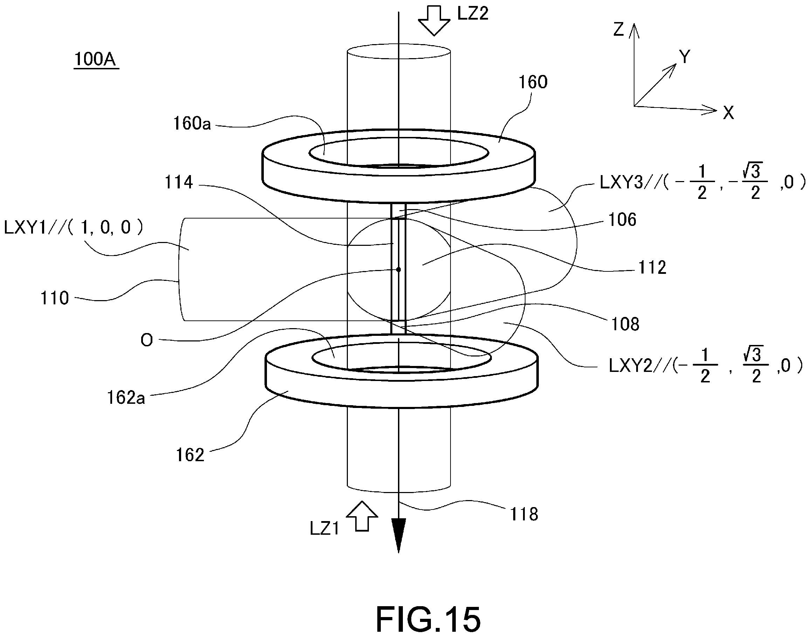

In the first and second embodiments described above, the three sets of laser beam pairs LX, LY, and LZ orthogonal to one another are described as an example corresponding to the first set of light beams. FIG. 15 illustrates a further example corresponding to the first set of light beams. As illustrated in FIG. 15, a combination of a total of five laser beams, LXY1, LXY2, LXY3, LZ1, and LZ2 may be used as the first set of light beams. The laser beam LZ is composed of a laser beam LZ1 traveling in the positive direction on the Z axis and a laser beam LZ2 traveling in the negative direction on the Z axis. The laser beam LXY1 travels in the positive direction on the X axis. The laser beam LXY2 travels in +120 degree direction from positive X axis in XY plane. The laser beam LXY3 travels in -120 degree direction from positive X axis in XY plane relative to the laser beam LXY1. The magneto-optical trap formed by a combination of five laser beams has been proposed in Japanese Patent Application 2022-014486.

In the first and second embodiments described above, the laser beam pair LZ may be generated from a single laser beam by means of a mirror. In this configuration, to eject cold atoms to a device on the following side, the mirror may have a hole to allow the cold atoms to pass through. In a further example, to eject the cold atoms to a device on the following side, a deflector composed of a resonant laser beam may be used. The deflector has a function to deflect the cold atoms to a desired direction.

### <Magneto-Optical Trap Device according to Third Embodiment>

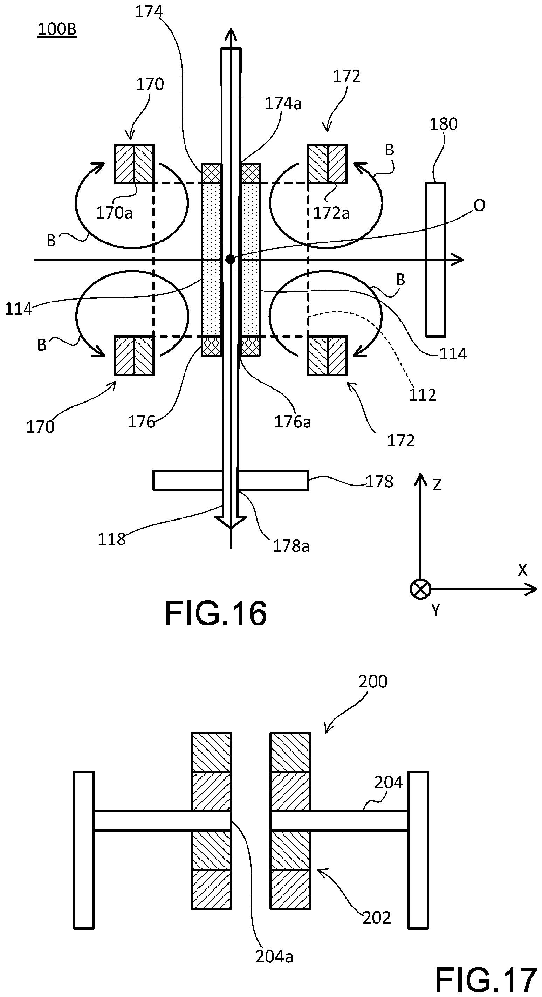

A magneto-optical trap device 100B according to a third embodiment will be described below by reference to FIG. 16. FIG. 16 is a cross sectional view schematically illustrating a configuration of the magneto-optical trap device 100B according to the third embodiment.

The magneto-optical trap device 100B according to the third embodiment includes a pair of magnets and a pair of mask members. The pair of magnets is composed of annular magnets 170 and 172, and the pair of mask members is composed of annular mask members 174 and 176. The mask members 174 and 176 correspond to an example of the second former.

The magnet 170 has, in the center, a hole 170a passing through the magnet 170 in the magnetization direction. The magnet 172 has, in the center, a hole 172a passing through the magnet 172 in the magnetization direction. In the third embodiment, the magnets 170 and 172 are magnetized along the X axis. In other words, the magnets 170 and 172 are disposed on the X axis such that the magnetization direction is parallel to the X axis direction. More specifically, the magnets 170 and 172 are disposed such that the magnetization direction of the magnet 170 and the magnetization direction of the magnet 172 are opposite to each other with respect to the center O of the intersecting region 112. The distance between the magnet 170 and the center O is equal to the distance between the magnet 172 and the center O. The diameter of the holes 170a and 172a is larger than the diameter of the laser beam pair LX. The magnets 170 and 172 are disposed not to interrupt traveling of the laser beam pairs LY and LZ. In other words, the length between the magnet 170 and the magnet 172 is longer than the diameter of the laser beam pairs LY and LZ.

The mask member 174 has, in the center, a hole 174a passing through the mask member 174 in the thickness direction. The mask member 176 has, in the center, a hole 176a passing through the mask member 176 in the thickness direction. The mask members 174 and 176 are disposed on the Z axis on the opposite sides with respect to the center O of the intersecting region 112. The distance between the mask member 174 and the center O is equal to the distance between the mask member 176 and the center O. The outer diameter of the mask members 174 and 176 is smaller than the diameter of the laser beam pair LZ. The laser beam pair LZ is partially blocked by the mask members 174 and 176.

The laser beam 118 for optically trapping the atoms irradiates the atom trap space through the hole 174a of the mask member 174 and the hole 176a of the mask member 176.

The mask members 174 and 176 are made of a paramagnetic material. The paramagnetic material is capable of blocking part of the laser beam pair LZ without any optical force. The mask members 174 and 176 are used only for the purpose of masking. Therefore, contamination of the sides of the mask members 174 and 176 facing the intersecting region 112 with atomic beam would not cause any problems.

The magneto-optical trap device 100B further includes mirrors 178 and 180. The mirror 178 has, in the center, a hole 178a passing through the mirror 178 in the thickness direction. The mirror 178 is disposed on the Z axis at a location further away from the center O than the mask member 176. The laser beam 118 travels through the hole 178a. One of the laser beams (the laser beam LZ2, for example) of the laser beam pair LZ is reflected by the mirror 178 to thereby generate the other laser beam (the laser beam LZ1, for example).

The mirror 180 is disposed on the X axis at a location further away from the center O than the magnet 172. One of the laser beams of the laser beam pair LX is reflected by the mirror 180 to thereby generate the other laser beam of the pair.

The mirrors 178 and 180 are only one example optical element that generates the laser beam pair, and other optical elements (a beam splitter, for example) may be used for generating the laser beam pair. This is also true in the first and second embodiments.

In the third embodiment, similar to the first and second embodiments described above, atoms are definitely given a momentum with respect to the traveling direction of the laser beam 118 to be extracted from the intersection region 11.

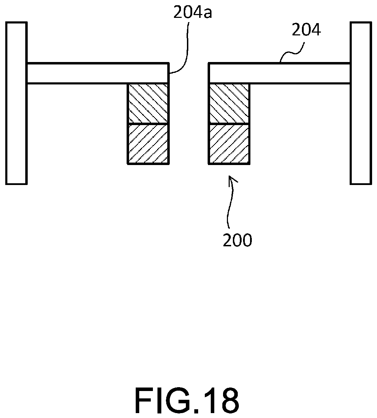

A method of mounting annular magnets (the magnets 106 and 108, for example) will be described below by reference to FIG. 17 and FIG. 18. FIG. 17 and FIG. 18 are cross sectional views each illustrating annular magnets. A possible example method includes a method in which annular magnets are attached to a disk plate such as glass and sapphire that transmits light, and the disk plate is then mounted on a portion of the magneto-optical trap device.

In the example illustrated in FIG. 17, a disk plate 204 has, in the center, a hole 204a. A magnet 200 is disposed on one side of the disk plate 204 and a magnet 202 is disposed on the opposite side of the disk plate 204. The magnets 200 and 202 are attached to the disk plate 204 with their own magnetic force across the disk plate 204.

In the example illustrated in FIG. 18, the magnet 200 is attached to the disk plate 204 with low outgassing adhesive or by ultrasonic soldering using indium.

In a further example, a portion of the glass surface is metallized by metallic plating technique and the magnet 200 attached to the portion by indium soldering.

While in the above examples the optical lattice clock has been described, those skilled in the art would be able to apply the techniques of each embodiment described above to structures other than the optical lattice clock. Specifically, the techniques may be applied to atomic clocks other than the optical lattice clock, or to an atomic interferometer that is an interferometer for use with atoms. For example, a physics package for an atomic clock or a physics package for an atomic interferometer including the magneto-optical trap device 100, the magneto-optical trap device 100A, or the magneto-optical trap device 100B may be provided. The first to third embodiments may be applied to various quantum information processing devices for atoms or ionized atoms. Here, the quantum information processing device refers to a device that performs measurement, sensing, and information processing based on quantum states of atoms and light, and may include, in addition to the atomic clock and the atomic interferometer, a magnetic field meter, an electric field meter, a quantum computer, a quantum simulator, and a quantum repeater, for example. The physics package for a quantum information processing device, when the techniques of the first to third embodiments are applied, achieves size reduction or transportability, similar to the physics package for the optical lattice clock. It should be noted that, in these devices, the clock transition space may be used not as a space targeted for time measurement, but as a space in which atomic spectroscopy and interrogation of clock transition are caused.

While in the above description, specific configurations are described for ease of understanding, these configurations only exemplify the embodiments, and various other embodiments may be employed.

### REFERENCE SIGNS LIST

100, 100A, 100B magneto-optical trap device, 102 atom trap space, 104 first irradiation device, 106, 108 magnet, 112 intersecting region, 116 second irradiation device, 118 laser beam.

## Claims

1. A magneto-optical trap device comprising:
a first former configured to form an atom trap space in which atoms are trapped with a first set of light beams and a magnetic field;
a second former configured to form a non-atom-trap space within an intersecting region where light beams in the first set intersect; and
a light beam irradiator configured to irradiate the intersecting region with a second light beam to enable atoms within the non-atom-trap space to be extracted from the intersecting region.

2. The magneto-optical trap device according to claim 1, wherein
the first former and the second former include a pair of magnets configured to generate a magnetic field,
each of the magnets has a hole to allow a light beam to pass through, and
the light beam irradiator irradiates the intersecting region with the second light beam passing through the hole.

3. The magneto-optical trap device according to claim 2, wherein
the pair of magnets is disposed on a light path along which part of the first set of light beams travels to partially block part of the first set of light beams,
the atom trap space is formed between the magnets of the pair by light beams of the first set of light beams that are not blocked with the pair of magnets and a magnetic field generated by the pair of magnets, and
the non-atom trap space is formed in a space where light beams are blocked by the pair of magnets.

4. The magneto-optical trap device according to claim 3, further comprising:
an auxiliary magnet configured to form the atom trap space.

5. The magneto-optical trap device according to claim 1, wherein
the second former comprises a pair of masks each having a hole to allow a light beam to pass through,
the pair of masks is disposed on a light path along which part of the first set of light beams travels to partially block part of the first set of light beams, and
the light beam irradiator irradiates the intersecting region with the second light beam passing through the hole.

6. The magneto-optical trap device according to claim 5, wherein
the pair of masks comprises a paramagnetic material.

7. The magneto-optical trap device according to claim 1, wherein
the second light beam is a push laser beam.

8. The magneto-optical trap device according to claim 1, wherein
the first set of light beams are laser beams having a wavelength of 461 nm or laser beams having a wavelength of 689 nm.

9. A physics package comprising:
the magneto-optical trap device according to any one of claims 1 to 8.

10. A physics package for an optical lattice clock, comprising:
the physics package according to claim 9.

11. A physics package for an atomic clock, comprising:
the physics package according to claim 9.

12. A physics package for an atomic interferometer, comprising:
the physics package according to claim 9.

13. A physics package for a quantum information processing device for atoms or ionized atoms, comprising:
the physics package according to claim 9.

14. A physics package system comprising:
the physics package according to claim 9; and
a control device configured to control an operation of the physics package.
